# EUROPEAN PATENT SPECIFICATION

(11) **EP 3 726 538 B1**
(45) Date of publication and mention of the grant of the patent: **27.12.2023**
(21) Application number: 18888515.6
(22) Date of filing: 07.11.2018
(51) Int. Cl.: C08G 59/68, C08K 5/19, C08L 33/04, C08L 63/00, H01B 1/22, C08K 5/42, C08K 3/08, H01L 31/0224, C08J 3/20

(54) **CONDUCTIVE PASTE**
LEITPASTE
PÂTE CONDUCTRICE

(30) Priority: 13.12.2017 JP 2017238568
(43) Date of publication of application: 21.10.2020
(73) Proprietor: Namics Corporation, Niigata-shi, Niigata 950-3131 (JP)
(72) Inventor: MURAMATSU, Kazuo, Niigata-shi, Niigata 950-3131 (JP); TANABE, Hideo, Niigata-shi, Niigata 950-3131 (JP)
(74) Representative: Hoffmann Eitle
(86) International application number: PCT/JP2018/041303
(87) International publication number: WO 2019/116787

(56) References cited:
- DE-A1-102016 207 548
- JP-A- 2014 089 818
- JP-A- 2015 507 680
- JP-A- 2017 066 218
- DATABASE WPI Week 201728 Thomson Scientific, London, GB; AN 2017-23149B XP002803692, & JP 2017 066242 A (HITACHI CHEM CO LTD) 6 April 2017 (2017-04-06)
- DATABASE WPI Week 201454 Thomson Scientific, London, GB; AN 2014-J28746 XP002803693, & JP 2014 089818 A (NAMICS CORP) 15 May 2014 (2014-05-15)
- DATABASE WPI Week 201548 Thomson Scientific, London, GB; AN 2015-38290H XP002803694, & KR 2015 0070695 A (KOREA ELECTRONICS TECHNOLOGY INST) 25 June 2015 (2015-06-25)
- DATABASE WPI Week 201366 Thomson Scientific, London, GB; AN 2013-D30678 & KR 2013 0020367 A (DONGWOO FINE CHEM CO LTD) 27 February 2013 (2013-02-27)

## Description

### TECHNICAL FIELD

The present invention relates to a conductive paste capable of forming a conductive pattern having excellent electrical characteristics. Specifically, the present invention relates to a thermosetting conductive paste that can be used to form electrodes and circuit patterns in devices such as semiconductor devices and electronic components.

### BACKGROUND ART

Conductive pastes containing silver particles are used to form, for example, electrodes and circuit patterns in semiconductor devices and electronic components. Electrodes and circuit patterns may be formed with a conductive paste by applying the conductive paste onto the surface such as a substrate in a predetermined pattern by a screen printing method or the like, and thereafter heating the conductive paste to form a conductive film in the predetermined pattern.

There are two types of conductive pastes, i.e., high-temperature firing type conductive pastes and thermosetting conductive pastes. High-temperature firing type conductive pastes are pastes which are capable of forming conductive films by being fired at a high temperature of about 550 to 900°C. In the case of a high-temperature baking type conductive paste, the resin component contained in the conductive paste is burned off during firing. Thermosetting conductive pastes are pastes that can form conductive films by heating at a relatively low temperature of about room temperature (around 20°C) to 250°C. In the case of a thermosetting conductive paste, a conductive film is formed by the curing of the resin component for binding the silver particles to one another.

Patent document 1 describes an example of thermosetting conductive pastes (compositions). Specifically, Patent document 1 describes a thermosetting conductive paste containing (A) silver particles, (B) an oxetanyl group-containing polysilsesquioxane, (C) a phthalic acid-based glycidyl ester epoxy resin and (D) a cationic polymerization initiator.

Patent documents 2 to 5 describe various compositions including polymerization initiators.

Patent document 2 describes an adhesive tape composition including, based on the total weight of the adhesive tape composition, 25% by weight to 75% by weight of an acrylate monomer, 20% by weight to 70% by weight of an epoxy resin, 0.001% by weight to 3% by weight of a radical photoinitiator, 0% by weight to 10% by weight of fumed silica, and 0.02 to 5% by weight of a cationic thermal initiator.

Patent document 3 describes a film-forming composition which contains a polysiloxane represented by a specific formula and a quaternary ammonium salt as a thermal acid generator.

Patent document 4 describes a resist underlayer film-forming composition which includes a polymer having structural units represented by specific formulas, and a solvent including more than 50% by weight of propylene glycol monomethyl ether.

Patent document 5 describes a resist underlayer film-forming composition which includes a copolymer having structural units represented by specific formulas, a crosslinkable compound, a crosslinking catalyst and a solvent.
Patent Document 6 relates to a thermally curable adhesive composition comprising an epoxy-functionalized (co)polymer, a thermally activatable curing agent for cationic curing of epoxides and at least one type of matrix polymer as film former.
Patent Document 7 relates to a liquid composition for sealing comprising an epoxy compound, an oxetane compound, a polymerization initiator and an inorganic filler. Patent Document 8 relates to allow temperature curable conductive paste composition comprising a reactive silver precursor for organic solvents and conductive material, a thermosetting resin and an additive.

### PRIOR ART REFERENCES

### Patent document

Patent document 1: JP 2014-89818
Patent document 2: JP 2015-507680
Patent document 3: JP 2016-69624
Patent document 4: WO 2014/109186
Patent document 5: WO 2015/098525
Patent document 6: DE 10 2016 207548 A1
Patent document 7: JP 2017-066242
Patent document 8: KR 2015 0070695 A

### SUMMARY OF THE INVENTION

### Problems to be Solved by the Invention

A conductive film obtained using a thermosetting conductive paste tends to be higher in specific resistance (electrical resistance value) than a conductive film obtained using a high-temperature firing type conductive paste. For example, thermosetting conductive pastes, which in general use an epoxy resin as a binder, generally need to be heat treated at a high temperature of above 250°C in order to achieve good adhesion and electrical characteristics (specific resistance of not more than 10 µΩ·cm).

An object of the present invention is to provide a thermosetting conductive paste that can be treated at a low temperature (for example, not more than 250°C) to give a conductive film with a low specific resistance.

### Means to Solve the Problems

To achieve the above object, the present invention has the following configurations.

### (Configuration 1)

Configuration 1 of the present invention is a conductive paste comprising (A) a conductive component, (B) a thermosetting resin, (C) a compound having a structure of the formula (1), and (D) a solvent, wherein the compound (C) having the structure of the formula (1) is included in an amount of 0.1 part by weight to 2.0 parts by weight with respect to 100 parts by weight of the conductive component (A).

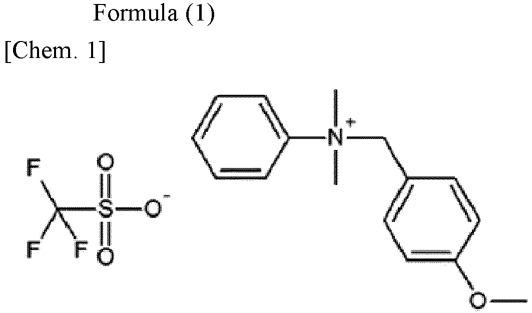

The thermosetting conductive paste obtained according to Configuration 1 of the present invention can be treated at a low temperature (for example, not more than 250°C) to give a conductive film with a low specific resistance.

### (Configuration 2)

Configuration 2 of the present invention is the conductive paste according to Configuration 1, wherein the conductive component (A) comprises at least one selected from Ag and Cu.

According to Configuration 2 of the present invention, a conductive film with a lower specific resistance can be obtained by using the metal with a low specific resistance.

### (Configuration 3)

Configuration 3 of the present invention is the conductive paste according to Configuration 1 or 2, wherein the conductive component (A) comprises spherical particles and/or flaky particles.

According to Configuration 3 of the present invention, as particles of the conductive component are spherical particles and/or flaky particles, better conduction between the particles can be obtained.

### (Configuration 4)

Configuration 4 of the present invention is the conductive paste according to any one of Configurations 1 to 3, wherein the thermosetting resin (B) comprises an epoxy resin or an acrylic resin.

According to Configuration 4 of the present invention, the thermosetting resin can be thermally cured reliably.

### (Configuration 5)

Configuration 5 of the present invention is the conductive paste according to any one of Configurations 1 to 4, which includes the compound (C) having the structure of the formula (1) in an amount of 0.21 part by weight to 1.68 parts by weight with respect to 100 parts by weight of the conductive component (A).

According to Configuration 5 of the present invention, a conductive film with a low specific resistance can be obtained more reliably as a result of the amount of the compound having the structure of the formula (1) being limited to the specified proportion.

### (Configuration 6)

Configuration 6 of the present invention is the conductive paste according to any one of Configurations 1 to 5, wherein the solvent (D) comprises ethyl glycol monophenyl ether or butyl carbitol acetate.

According to Configuration 6 of the present invention, the viscosity of the conductive paste can be controlled appropriately by using the specified solvent.

### (Configuration 7)

Configuration 7 of the present invention is the conductive paste according to any one of Configurations 1 to 6, further comprising (E) a phenoxy resin.

According to Configuration 7 of the present invention, a conductive film having a further lower electroresistance can be obtained by the conductive paste further containing a phenoxy resin.

### (Configuration 8)

Configuration 8 of the present invention is the conductive paste according to any one of Configurations 1 to 7, further comprising (F) a coupling agent.

According to Configuration 8 of the present invention, since the coupling agent is contained as an additional component in the conductive paste, enhanced bonds between the thermosetting resin and the inorganic components such as the conductive component can be obtained.

### (Configuration 9)

Configuration 9 of the present invention is a use of the conductive paste described in any one of Configurations 1 to 8 for forming a solar cell electrode.

The conductive paste of the present invention may be preferably used as a conductive paste for forming solar cell electrode. In particular, the conductive paste of the present invention may be preferably used as a conductive paste for forming electrodes in solar cells using thin film materials such as amorphous silicon, for example, amorphous silicon solar cells, heterojunction solar cells and compound semiconductor solar cells (such as CIS (CuInSe₂) solar cells, CIGS (copper indium gallium selenide) solar cells and CdTe solar cells).

### (Configuration 10)

Configuration 10 of the present invention is a method for forming a solar cell electrode comprising treating the conductive paste according to any one of Configurations 1 to 8 at a temperature of not more than 250°C.

The conductive paste of the present invention is treatable at a temperature of not more than 250°C, and thus can form electrodes without adversely affecting the materials constituting the solar cell.

### (Configuration 11)

Configuration 11 of the present invention is a use of the conductive paste according to any one of Configurations 1 to 8 for forming an electrode on a surface of a transparent electrode.

The conductive paste of the present invention can form an electrode on the surface of a transparent electrode with a relatively low contact resistance without adversely affecting the transparent electrode.

### Effect of the Invention

The thermosetting conductive pastes provided according to the present invention can be treated at a low temperature (for example, not more than 250°C) to give conductive films with a low specific resistance.

### BRIEF DESCRIPTION OF THE DRAWINGS

[Fig. 1] Fig. 1 is a schematic sectional diagram illustrating an example of solar cells which have electrodes formed using a conductive paste.
[Fig. 2] Fig. 2 is a schematic plan diagram illustrating a specific resistance measurement pattern for an electrode formed using a conductive paste.
[Fig. 3] Fig. 3 is a schematic plan diagram illustrating a contact resistance measurement pattern used in the measurement of contact resistance between an electrode and a crystalline silicon substrate.
[Fig. 4] Fig. 4 is a SEM image of a cross-sectional state of a conductive film of Example 3 observed with an electron microscope (SEM).
[Fig. 5] Fig. 5 is a SEM image of a cross-sectional state of a conductive film of Comparative Example 1 observed with an electron microscope (SEM).

### MODE FOR CARRYING OUT THE INVENTION

Hereinbelow, embodiments of the present invention will be specifically described with reference to the drawings. The embodiments discussed below are only a specific illustration of the present invention and do not limit the scope of the present invention thereto.

A thermosetting conductive paste of the present invention (sometimes simply written as the "conductive paste"), by including specific components, can be thermally cured at a low temperature (for example, not more than 250°C) to form an electrode. Further, a conductive film (an electrode) having a low specific resistance can be obtained by using the conductive paste of the present invention.

In the present specification, the term "conductive film" means a pattern of a thin film produced by applying the conductive paste onto a predetermined surface such as a substrate by printing or the like to form a pattern with a predetermined shape, and curing the paste. The pattern with a predetermined shape may be a pattern with any shape, for example, a pattern formed by lines, dots or a plane.

The conductive paste of the present invention may be used to form conductive films as electrodes and circuit patterns in devices such as semiconductor devices and electronic components. The conductive paste of the present invention may be used to form electrodes and/or circuit patterns not only on the surface of inorganic materials such as semiconductors, oxides and ceramics, but also on substrates having low heat resistance such as PET (polyethylene terephthalate) and PEN (polyethylene naphthalate).

In the present specification, the term "semiconductor devices" means devices using semiconductor chips, for example, semiconductor devices such as transistors and integrated circuits, flat panel displays such as liquid crystal displays (LCD) and plasma display panels (PDP), and devices using semiconductors such as solar cells. The semiconductor devices are devices that utilize the properties of electrons and holes in a semiconductor, and have electrodes for direct or indirect electrical connection to the semiconductor.

In some cases, the electrodes in the semiconductor devices need to be light transmissive. Transparent conductive films are used as such electrode materials. Electrodes made of transparent conductive films are called transparent electrodes. The transparent electrodes are used in semiconductor devices including flat panel displays such as liquid crystal displays (LCD) and plasma display panels (PDP), and various solar cells. Examples of the solar cells include thin-film solar cells such as amorphous silicon solar cells and compound semiconductor solar cells (CIS solar cells, CIGS solar cells, CdTe solar cells, etc.), heterojunction solar cells, and crystalline silicon solar cells. The transparent electrodes are used for electrode formation in, for example, flat panel displays, thin-film solar cells, heterojunction solar cells and the like.

The transparent conductive films that are used as materials of the transparent electrodes may be oxide conductive films. Examples of the oxide conductive films include indium tin oxide (also written as "ITO (indium tin oxide)") thin films, tin oxide thin films and ZnO-based thin films. At present, ITO thin films are widely used in flat panel displays, and various solar cells, etc. To establish an electrical connection to a transparent electrode while avoiding interference with light incoming to the semiconductor device or with light outgoing from the semiconductor device, an electrode is formed with a grid shape (such an electrode is sometimes written simply as "electrode"). The conductive paste of the present invention may be used to form a grid-shaped electrode on the surface of a transparent electrode.

In the electrode forming process, the treatment is sometimes performed at a high temperature, for example, a temperature of more than 250°C. In such cases, semiconductor chips and/or other materials can be degraded depending on the types of the semiconductor materials in the semiconductor devices, the types of the materials of the electronic components, and the types of the materials other than the semiconductors constituting the semiconductor devices, the electronic components, etc. By using the conductive paste of the present invention, electrodes with a low specific resistance can be formed at a low temperature (for example, not more than 250°C). The use of the thermosetting conductive paste of the present invention allows predetermined low-resistance electrodes to be formed without thermal degradation of semiconductor devices.

When an electrode is formed on a transparent conductive film using the conductive paste of the present invention, low contact resistance can be obtained. When, in particular, an electrode is formed on an ITO thin film, low contact resistance (for example, contact resistance of 7 mΩ·cm² or less) can be obtained relatively easily. Thus, the conductive paste of the present invention may be suitably used to form an electrode on a transparent conductive film, particularly an ITO thin film.

The conductive paste of the present invention may be preferably used to form an electrode on the surface of a transparent conductive film in a solar cell. Some types of solar cells use materials that are adversely affected by a heating step at high temperature. The thermosetting conductive paste of the present invention may be particularly preferably used to form an electrode on the surface of a transparent conductive film in such a low-heat resistant solar cell. An example material that is adversely affected by a high-temperature heating step is amorphous silicon. Examples of the solar cells using amorphous silicon as a material include amorphous silicon solar cells, and heterojunction solar cells using amorphous silicon and crystalline silicon (hereinafter, simply written as "heterojunction solar cells"). The thermosetting conductive paste of the present invention may be preferably used to form electrodes on the surface of transparent conductive films in amorphous silicon solar cells and heterojunction solar cells.

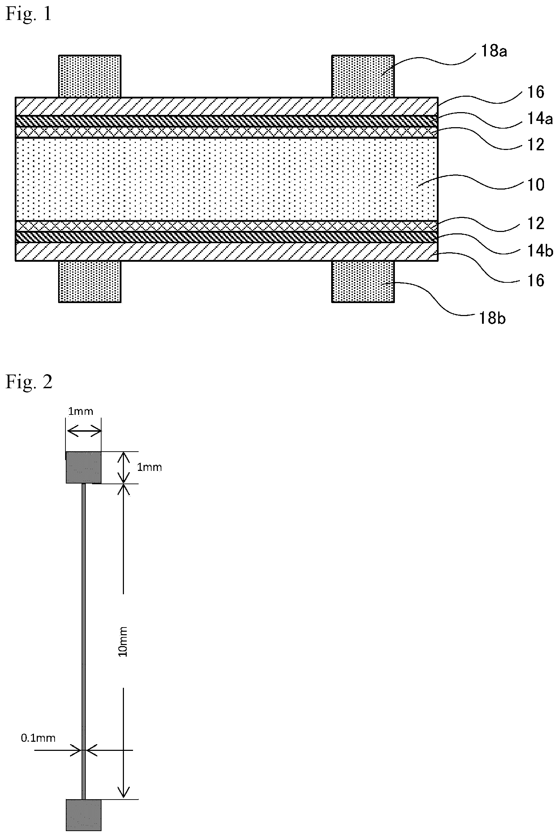

Heterojunction solar cells, which are a preferred application of the thermosetting conductive paste of the present invention, will be described with reference to Fig. 1.

Fig. 1 is a schematic sectional diagram illustrating an example of heterojunction solar cells. In the heterojunction solar cell illustrated in Fig. 1, an i-type amorphous silicon layer 12 made of intrinsic amorphous silicon (about 10 nm in film thickness) and a p-type amorphous silicon layer 14a made of p-type amorphous silicon (about 10 nm in film thickness) are stacked in this order on the surface on the incident side of an n-type crystalline silicon substrate 10 (for example, a single crystal silicon substrate or a polycrystalline silicon substrate). A transparent conductive film, for example, a transparent conductive film 16 made of indium tin oxide (ITO) (about 70 nm in film thickness) is disposed on the p-type amorphous silicon layer 14a. On the surface of the transparent conductive film 16, a grid-shaped light incident side electrode 18a is disposed to form a light incident side surface with a slit shape.

Further, as illustrated in Fig. 1, on the reverse side of the crystalline silicon substrate 10, an i-type amorphous silicon layer 12 made of intrinsic amorphous silicon (about 10 nm in film thickness) and an n-type amorphous silicon layer 14b made of highly doped n-type amorphous silicon (about 10 nm in film thickness) are stacked in this order. Similarly to the light incident side surface, a transparent conductive film 16 and a grid-shaped back electrode 18b are disposed on the n-type amorphous silicon layer 14b.

In the case of the heterojunction solar cell illustrated in Fig. 1, the layers except the crystalline silicon substrate may be each formed by a method such as a plasma CVD method, a sputtering method, a vapor deposition method or a screen printing method, at a temperature of about 200°C or below. Because a heating step at a high temperature adversely affects the amorphous silicon, the temperature at which the light incident side electrode 18a and the back electrode 18b are formed on the surface of the transparent conductive films 16 is preferably low. With the thermosetting conductive paste of the present invention, an light incident side electrode 18a and a back electrode 18b having low specific resistance can be formed at a low temperature (for example, not more than 250°C).

Next, the thermosetting conductive paste of the present invention will be described.

The present invention is a conductive paste comprising (A) a conductive component, (B) a thermosetting resin, (C) a compound having a structure of the formula (1), and (D) a solvent, wherein the compound (C) having the structure of the formula (1) is included in an amount of 0. 1 part by weight to 2.0 parts by weight with respect to 100 parts by weight of the conductive component (A).

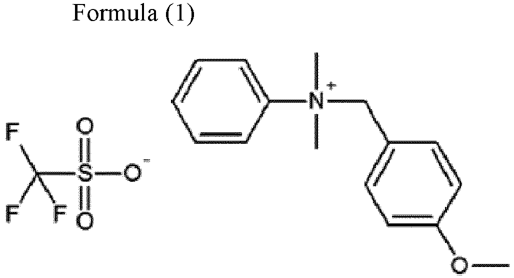

The thermosetting conductive paste according to the present invention can be treated at a low temperature (for example, not more than 250°C) to give a conductive film with low specific resistance.

### <(A) Conductive components>

The conductive paste of the present invention includes a conductive component (A).

The conductive component is conductive particles including a conductive component such as silver, copper, nickel, aluminum, zinc and/or tin. The shape of the conductive particles may be, for example, spheres, flakes, needles or the like. The conductive particles that are used may be a mixture of different shapes.

For example, the conductive particles may be produced by, although not particularly limited to, a reduction method, a pulverization method, an electrolysis method, an atomization method, a heat treatment method, or a combination thereof. The conductive particles in the form of flakes may be produced by, for example, crushing conductive spherical particles with a ball mill or the like.

In the conductive paste of the present invention, the conductive component (A) preferably comprises spherical particles and/or flaky particles.

From the point of view of reducing the specific resistance of a conductive film, it is preferable to use conductive flaky particles. When, however, the conductive particles that are used are all flakes, the conductive paste comes to exhibit a high viscosity and is difficult to handle (has high thixotropy). It is therefore preferable that the conductive particles contained in the conductive paste of the present invention be a mixture of conductive flaky particles and conductive spherical particles. The mixing ratio (the weight ratio) of the conductive flaky particles and the conductive spherical particles is preferably 1 for the conductive flaky particles and 0.25 to 4 for the conductive spherical particles. The mixing ratio is more preferably 1 for the conductive flaky particles and 0.67 to 1.5 for the conductive spherical particles. The mixing ratio of the conductive flaky particles to the conductive spherical particles is most preferably 1: 1.

The average particle size of the conductive particles is preferably 0.1 µm to 15 µm, more preferably 0.5 µm to 10 µm, and most preferably 0.5 µm to 5 µm. In the present specification, the average particle size means the average particle size based on the number distribution (average particle size at 50% of the accumulation of all the particles: D50) according to laser diffraction/scattering particle size distribution measurement. When the average particle size of the conductive particles is in the above range, electrodes and circuit patterns obtained by heating the conductive paste attain a good surface condition. Further, electrical characteristics of electrodes and circuit patterns obtained by heating the conductive paste is enhanced.

The content of the conductive component (A) in the conductive paste of the present invention is preferably 75 to 98% by weight, more preferably 80 to 97% by weight, and further more preferably 85 to 95% by weight relative to the whole of the conductive paste.

Regarding the conductive component (A) contained in the conductive paste of the present invention, it is preferable that the conductive component (A) comprise at least one selected from silver (Ag) and copper (Cu). Silver particles and/or copper particles may be used as the conductive component (A). Further, the conductive component (A) that is used may be silver-copper alloy particles alone or together with silver particles and/or copper particles. By using silver and/or copper which are metals of low specific resistance, a conductive film with low specific resistance can be obtained.

Silver particles have high conductivity. Thus, silver particles are conventionally used as electrodes for numerous semiconductor devices, for example, solar cells, and have high reliability. In the case of the conductive paste of the present invention, the use of silver particles as the conductive component makes it possible to produce highly reliable and high-performance semiconductor devices, for example, solar cells. For this reason, silver particles are preferably used as the main component of the conductive component.

Copper particles are preferable as an electrode material because they are relatively inexpensive and have high conductivity. By using copper particles as the conductive component, the cost of the conductive paste can be reduced.

The conductive paste of the present invention may include metal particles other than silver particles and/or copper particles, or may include particles of an alloy of silver and/or copper with an additional metal, while still ensuring that the performance of the paste in its application is not impaired. From the point of view of obtaining low electrical resistance and high reliability, the conductive component preferably includes silver particles in a proportion of not less than 80% by weight, and more preferably not less than 90% by weight relative to the whole of the conductive component. It is more preferable that the conductive component consist of silver particles only.

Incidentally, the phrase "the conductive component consists of silver particles only" means that the conductive component is substantially silver particles alone except inevitable impurities. That is, when the conductive component consists of silver particles only, the conductive component can contain inevitable impurities in addition to the silver particles. The same applies to components other than silver particles.

### <(B) Thermosetting resins>

The conductive paste of the present invention includes a thermosetting resin (B).

Examples of the thermosetting resins include amino resins such as urea resins, melamine resins and guanamine resins; high-molecular bisphenol A epoxy resins, branched polyfunctional bisphenol A epoxy resins such as p-glycidyloxyphenyl dimethyl tris-bisphenol A diglycidyl ether, bisphenol F epoxy resins, biphenyl epoxy resins such as diglycidyl biphenyl, novolak epoxy resins, tetrabromobisphenol A epoxy resins, tris(hydroxylphenyl)methane epoxy resins, alicyclic epoxy resins such as vinyl(3,4-cyclohexene) dioxide, (3,4-epoxycyclohexyl)methyl 3,4-epoxycyclohexylcarboxylate, bis(3,4-epoxy-6-methylcyclohexylmethyl) adipate and 2-(3,4-epoxycyclohexyl) 5, 1-spiro(3,4-epoxycyclohexyl)-m-dioxane, glycidyl ester epoxy resins such as diglycidyl hexahydrophthalate, diglycidyl 3-methylhexahydrophthalate and diglycidyl hexahydroterephthalate, glycidyl amine epoxy resins such as diglycidyl aniline, diglycidyl toluidine, triglycidyl-p-aminophenol, tetraglycidyl-m-xylylenediamine and tetraglycidyl bis(aminomethyl)cyclohexane, hydantoin epoxy resins such as 1,3-diglycidyl-5-methyl-5-ethylhydantoin, epoxy resins having a silicone skeleton such as 1,3-bis(3-glycidoxypropyl)-1,1,3,3-tetramethyldisiloxane; oxetane resins; phenol resins such as resol phenol resins, alkylresol phenol resins, novolak phenol resins, alkyl novolak phenol resins, aralkyl novolak phenol resins and allylphenols; silicone-modified resins such as silicone epoxies and silicone polyesters; bismaleimides, and polyimide resins.

In the conductive paste of the present invention, it is preferable that the thermosetting resin (B) comprise an epoxy resin or an acrylic resin. Further, in the conductive paste of the present invention, the thermosetting resin (B) preferably consists of only an epoxy resin, an acrylic resin or a mixture thereof. By using such a thermosetting resin, thermal curing may be accomplished reliably at a relatively low temperature.

### <(C) Compound having structure of formula (1)>

The conductive paste of the present invention includes a compound (C) having the structure of the formula (1).

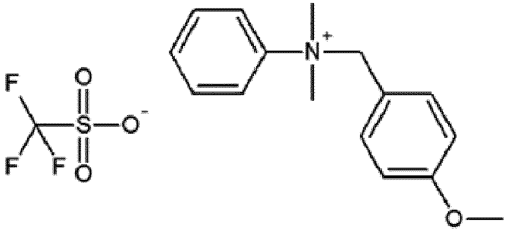

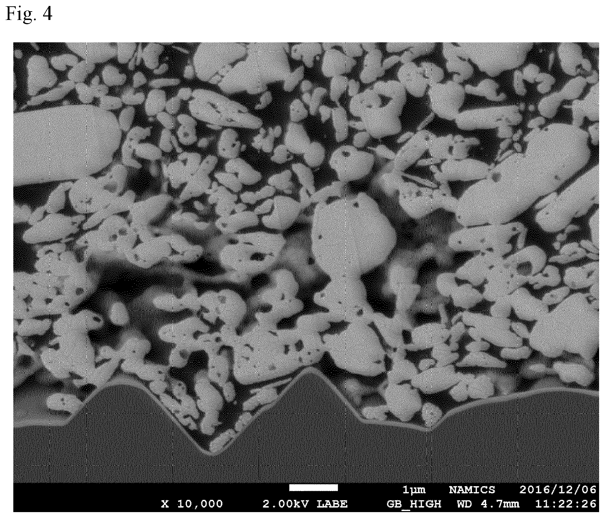

In the conductive paste of the present invention, the compound (C) having the structure of the formula (1) functions as a cationic polymerization initiator. The inventors of the present invention have found that the compound (C) with the structure of the formula (1) used as a cationic polymerization initiator enables the conductive paste to form a conductive film with low specific resistance. As shown in Fig. 4, a conductive film formed using the conductive paste of the present invention has an advanced level of the fusion of silver particles. The conductive paste of the present invention can offer low specific resistance probably because silver particles are fused to an advanced level. However, the present invention is not bound to this assumption.

The conductive paste of the present invention includes the compound (C) having the structure of the formula (1) in an amount of 0.1 part by weight to 2.0 parts by weight, preferably 0.15 to 1.7 parts by weight, and more preferably 0.21 to 1.68 parts by weight with respect to 100 parts by weight of the conductive component (A). By limiting the proportion of the compound having the structure of the formula (1) to the specified range, conductive films with low specific resistance can be obtained more reliably.

The compound (C) having the structure of the formula (1) does not induce the curing reaction until the predetermined temperature is reached. Thus, the conductive paste of the present invention has good storage stability. Specifically, the conductive paste of the present invention is excellent in stability over time and can be stored at room temperature.

The thermosetting conductive paste of the present invention may include an additional cationic polymerization initiator other than the above compound (C) having the structure of the formula (1) while still ensuring that the effects of the thermosetting conductive paste of the present invention are not impaired. Examples of such cationic polymerization initiators include p-toluenesulfonic acid salts, hexafluoroantimonic acid salts, hexafluorophosphoric acid salts, trifluoromethanesulfonic acid salts and perfluorobutanesulfonic acid salts. The thermosetting conductive paste of the present invention attains the specified effects by virtue of its containing the compound (C) with the structure of the formula (1). Thus, it is preferable that the thermosetting conductive paste of the present invention include the compound (C) with the structure of the formula (1) as the only cationic polymerization initiator.

### <(D) Solvents>

The conductive paste of the present invention includes a solvent (D). Viscosity of the conductive paste can be controlled by addition of the solvent (D).

Examples of the solvents contained in the conductive pastes of the present invention include aromatic hydrocarbons such as toluene, xylene, mesitylene and tetralin; ethers such as tetrahydrofuran; ketones such as methyl ethyl ketone, methyl isobutyl ketone, cyclohexanone and isophorone; lactams such as 2-pyrrolidone and 1-methyl-2-pyrrolidone; ether alcohols such as ethyl glycol monophenyl ether, ethylene glycol monomethyl ether, ethylene glycol monoethyl ether, ethylene glycol monobutyl ether, diethylene glycol monomethyl ether, diethylene glycol monoethyl ether, diethylene glycol monobutyl ether (butyl carbitol), and propylene glycol derivatives corresponding to the above ethers; esters, such as acetate esters, corresponding to the above ethers (for example, butyl carbitol acetate); and diesters such as methyl esters or ethyl esters of dicarboxylic acids such as malonic acid and succinic acid. Of these, at least one selected from ethyl glycol monophenyl ether and butyl carbitol acetate may be preferably used.

When the conductive paste of the present invention is applied to the surface of a transparent conductive film or the like by screen printing, the apparent viscosity of the conductive paste at room temperature is preferably 100 to 1000 Pa s, more preferably 200 to 800 Pa·s, and further more preferably 300 to 600 Pa·s. The value of viscosity that is used may be measured with a Brookfield viscometer: HBD model (manufactured by Brookfield) at a rotational speed of 5 rpm and a temperature of 25°C. The viscosity of the conductive paste may be controlled to a predetermined range by manipulating the amount of the solvent (D) in the conductive paste.

In the conductive paste of the present invention, the solvent (D) preferably comprises ethyl glycol monophenyl ether or butyl carbitol acetate. By using the specified solvent, the viscosity of the conductive paste may be controlled more appropriately, and enhancements may be achieved in printing characteristics of conductive films that are printed. Specifically, a conductive film, when printed in a thin line pattern, can achieve a thin and constant line width, a constant film thickness, and a high aspect ratio.

### <Other components>

The conductive paste of the present invention may include the following components in addition to the components (A), (B), (C) and (D) described above.

The conductive paste of the present invention may include a thermoplastic resin. Examples of the thermoplastic resins include novolak phenol resins, phenoxy resins, butyral resins, cellulose resins, acrylic resins, methacrylic resins, polyester resins, polyurethane resins, polyamide resins, thermoplastic xylene resins, hydroxystyrene polymers, cellulose derivatives, and mixtures of two or more of these resins.

The conductive paste of the present invention preferably further includes (E) a phenoxy resin as a thermoplastic resin. When the conductive paste further includes a phenoxy resin, conductive films having further lower electrode resistance may be obtained.

The conductive paste of the present invention preferably further includes (F) a coupling agent. When the conductive paste further includes a coupling agent, the bonding of the thermosetting resin with the inorganic components such as the conductive component may be further enhanced.

The conductive paste of the present invention may further include at least one selected from the group consisting of inorganic pigments, organic pigments, leveling agents, thixotropic agents and antifoaming agents.

The conductive paste of the present invention may be produced by any method without limitation. The conductive paste of the present invention may be produced by admixing the components in predetermined proportions with a mixer such as a grinding kneader, a propeller stirrer, a kneader, a three-roll mill or a pot mill.

The conductive paste of the present invention may be applied to the surface of a transparent electrode or the like by a known method such as a screen printing method. After the conductive paste is applied to the surface of a transparent electrode or the like, the conductive paste may be cured by heating at a predetermined temperature to form a conductive film.

When the conductive paste is thermally cured at an elevated temperature, the treatment temperature during the electrode formation is preferably not more than 250°C, and more preferably not more than 200°C. Specifically, the heating temperature for the thermal curing of the conductive paste is preferably 60 to 250°C, more preferably 60 to 200°C, and further more preferably 100 to 200°C.

The thickness of the conductive paste applied to the surface of a transparent electrode or the like is preferably 10 to 100 µm, more preferably 15 to 80 µm, and further more preferably 20 to 50 µm.

A conductive film obtained by heating the conductive paste of the present invention characteristically has high bond strength with respect to the substrate, low specific resistance (high conductivity), and low contact resistance. Thus, favorable electrodes may be formed on semiconductor devices or the like by the use of the thermosetting conductive paste of the present invention, without causing thermal degradations of the semiconductor devices or the like.

The conductive paste of the present invention may be used to form, for example, electrodes and circuit patterns in semiconductor devices and electronic components. The conductive paste of the present invention may be used to form circuit patterns and electrodes not only on semiconductor substrates, ceramic substrates and the like, but also on substrates having low heat resistance such as PET (polyethylene terephthalate) and PEN (polyethylene naphthalate).

When an electrode is formed on the surface of a transparent conductive film such as an ITO thin film using the thermosetting conductive paste of the present invention, low contact resistance can be obtained. When, in particular, an electrode is formed on an ITO thin film, low contact resistance (for example, a contact resistance of not more than 7 mΩ·cm²) can be obtained relatively easily. Thus, the thermosetting conductive paste of the present invention may be suitably used to form an electrode on the surface of a transparent conductive film, particularly a transparent electrode made of an ITO thin film.

The conductive paste of the present invention may be preferably used as a conductive paste for forming solar cell electrode. In particular, the conductive paste of the present invention may be preferably used as a conductive paste for forming electrodes in solar cells using thin film materials such as amorphous silicon-based materials, for example, amorphous silicon solar cells, heterojunction solar cells and compound semiconductor solar cells (such as CIS solar cells, CIGS solar cells and CdTe solar cells). Thin film materials such as amorphous silicon-based materials are vulnerable to high temperatures. By using the conductive paste of the present invention, electrodes may be formed at a relatively low temperature. The conductive paste of the present invention may be particularly preferably used to form electrodes in heterojunction solar cells having relatively high conversion efficiency, such as one illustrated in Fig. 1.

The treatment temperature at the time of electrode formation with the conductive paste for forming solar cell electrode of the present invention is preferably not more than 250°C, and more preferably not more than 200°C. When the electrode formation is formed at such a temperature, thin film materials vulnerable to high temperatures may be prevented from adverse effects.

### EXAMPLES

Examples and Comparative Examples of the present invention will be described hereinbelow.

### [Preparation of conductive pastes]

The materials shown in Table 4 were provided as raw materials for conductive pastes. Tables 1 to 3 describe the formulations of the materials in Examples 1 to 17 and Comparative Examples 1 to 4. The proportions described in Tables 1 to 3 are parts by weight with respect to 100 parts by weight of a conductive component.

### (A) Conductive components

Two types of silver particles A and B described in Table 4 were used as conductive components in the proportions shown in Tables 1 to 3.

Silver particles A: Flaky particles with an average particle size of 3 µm.

Silver particles B: Spherical particles with an average particle size of 1 µm.

### (B) Thermosetting resins

Three types of epoxy resins A, B and C described in Table 4 were used as thermosetting resins in the proportions shown in Tables 1 to 3.
Epoxy resin A: Alicyclic epoxy resin.
Epoxy resin B: Bis A epoxy resin.
Epoxy resin C: Polyfunctional epoxy resin.

### (C) Cationic polymerization initiators

Five types of cationic polymerization initiators A to E described in Table 4 were used as cationic polymerization initiators in the proportions shown in Tables 1 to 3.

Cationic polymerization initiator A: Cationic polymerization initiator which is a compound having the structure of the formula (1) and is shown in Table 4 as polymerization initiator A.

Cationic polymerization initiator B: Cationic polymerization initiator which is a compound having a structure other than the formula (1) and is shown in Table 4 as polymerization initiator B.

Cationic polymerization initiator C: Cationic polymerization initiator which is a compound having a structure other than the formula (1) and is shown in Table 4 as polymerization initiator C.

Cationic polymerization initiator D: Cationic polymerization initiator which is a compound having a structure other than the formula (1) and is shown in Table 4 as polymerization initiator D.

Cationic polymerization initiator E: Cationic polymerization initiator which is a compound having a structure other than the formula (1) and is shown in Table 4 as polymerization initiator E.

### (D) Solvents

Two types of solvents A and B described in Table 4 were used as solvents in the proportions shown in Tables 1 to 3.

### (E) Phenoxy resin

The phenoxy resin described in Table 4 was used in the proportions shown in Tables 1 to 3.

### (F) Coupling agent

The coupling agent described in Table 4 was used in the proportions shown in Tables 1 to 3.

The components (A) to (F) were mixed together in the weight ratios shown in Tables 1 to 3 to give conductive pastes of Examples 1 to 17 and Comparative Examples 1 to 4.

Next, the above materials having the predetermined formulations were each mixed with a planetary mixer and further dispersed into a paste with a three-roll mill. Conductive pastes were thus prepared.

### [Measurement of specific resistance]

The conductive pastes of Examples 1 to 17 and Comparative Examples 1 to 4 were heated to form conductive films, which were then tested to measure the specific resistance (the electrical resistivity).

The specific resistances of Examples 1 to 17 and Comparative Examples 1 to 4 were measured by the following procedure. First, an alumina substrate having a width of 15 mm, a length of 15 mm and a thickness of 200 µm was provided. The conductive paste was printed on the substrate through a 325 mesh stainless steel screen to form a pattern shown in Fig. 2.

Next, the patterns formed on the substrates using the conductive pastes of Examples 1 to 17 and Comparative Examples 1 to 4 were heated at 200°C for 30 minutes to give specific resistance measurement samples.

The specific resistance measurement samples obtained by heating the conductive pastes of Examples 1 to 17 and Comparative Examples 1 to 4 were tested with Multimeter 2001 manufactured by TOYO Corporation to measure the specific resistance of the conductive film patterns by a four-terminal sensing method. The measurement results are described in Tables 1 to 3.

Four samples for the specific resistance measurement were fabricated under the same conditions, and the measured value was obtained by average of the four samples.

As seen from Tables 1 to 3, the specific resistances (the electrical resistivities) of the conductive films obtained from the conductive pastes of Examples 1 to 17 of the present invention were 9.9 µΩ·cm (Example 8) and below. In general, it can be said that films with a specific resistance of 10 µΩ·cm or less may be suitably used as electrodes. In contrast, the specific resistances (the electrical resistivities) of the conductive films obtained from the conductive pastes of Comparative Examples 1 to 4 were in the range of 12.7 µΩ·cm (Comparative Example 3) to 22.7 µΩ·cm (Comparative Example 1). It has been thus demonstrated that the conductive pastes of Examples 1 to 17 of the present invention can form conductive films with lower specific resistance.

### [Measurement of contact resistance]

Electrodes were formed using the conductive pastes of Examples 1 to 17 and Comparative Examples 1 to 4 on the surface of crystalline silicon substrates having a transparent conductive film, and the contact resistance was measured. Specifically, the conductive pastes of Examples 1 to 17 and Comparative Examples 1 to 4 were each screen-printed onto the transparent conductive film disposed on the surface of the crystalline silicon substrate to form a contact resistance measurement pattern, which was then heated to form a contact resistance measurement electrode.

The substrates used here were n-type crystalline silicon substrates (substrate thickness: 200 µm).

Next, a transparent conductive film was formed on the surface of the n-type crystalline silicon substrate. Specifically, an indium tin oxide thin film (an ITO thin film) was formed by a sputtering method using a sputtering target containing indium oxide and tin oxide. The sheet resistance of the ITO thin film obtained was 80 Ω/square. The contact resistance measurement substrates obtained in this manner were used in the fabrication of the contact resistance measurement electrodes.

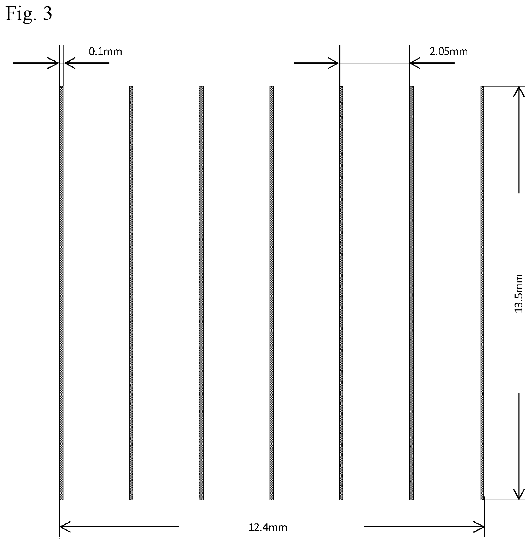

The conductive pastes were printed onto the contact resistance measurement substrates by a screen printing method. The contact resistance measurement patterns printed on the substrates were about 30 µm in film thickness. The patterns were then heated at 200°C for 30 minutes. Contact resistance measurement samples were thus obtained. Fig. 3 shows a schematic plan diagram of the contact resistance measurement pattern used for the measurement of contact resistance. The contact resistance measurement pattern illustrated in Fig. 3 is a pattern composed of seven rectangular electrode 0.1 mm in width and 13.5 mm in length which are arranged with pitch intervals of 2.05 mm.

Three samples for the contact resistance measurement were fabricated under the same conditions, the measured value was obtained by average of the three samples.

The contact resistance was determined by measuring the electrical resistance between predetermined rectangular electrodes in the pattern illustrated in Fig. 3 by TLM (a transfer length method) using GP 4TEST Pro manufactured by GP Solar. A contact resistance of not more than 10 mΩ·cm² is acceptable for use as electrodes on transparent conductive films. A contact resistance of not more than 7 mΩ·cm² is preferable for use as electrodes on transparent conductive films.

As seen from Tables 1 to 3, the contact resistances of the conductive films obtained from the conductive pastes of Examples 1 to 17 and Comparative Examples 1 to 4 with respect to the transparent conductive film (the ITO thin film) were 6.4 mΩ·cm² (Example 14) and below. Thus, it can be said that the contact resistances of Examples 1 to 17 are within the numerical range suited for use as electrodes on transparent conductive films. Incidentally, it can be said that Comparative Examples 1 to 4, which resulted in high specific resistances, showed good values of contact resistance.

### [Evaluation of printing characteristics]

Printing characteristics were evaluated by measuring the shapes of the contact resistance measurement patterns described above. The shapes of the contact resistance measurement patterns were measured with confocal microscope OPTELICS H1200 and surface roughness profiler 1500SD2 manufactured by Lasertec Corporation. The conductive pastes of Examples 1 to 17 and Comparative Examples 1 to 4 showed good printing characteristics on the surface of the transparent conductive films (the ITO thin films) as indicated by the symbol "O" in Tables 1 to 3.

### [Evaluation of conductive films using electron microscope]

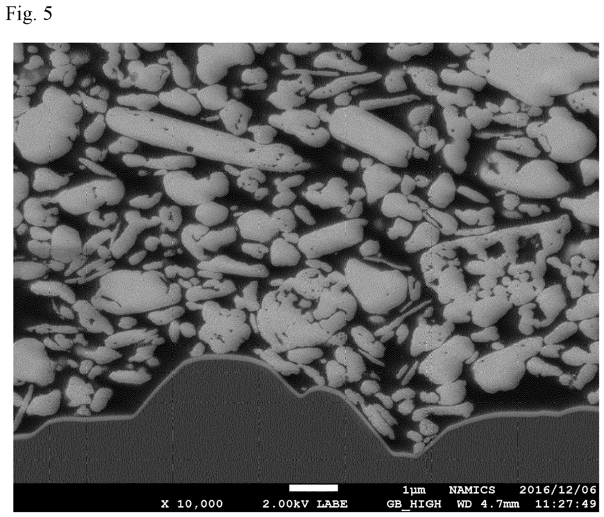

Of the conductive films obtained above for the measurement of specific resistance, the conductive films of Example 3 and Comparative Example 1 were observed on an electron microscope to evaluate their cross-sectional states. In the cross-sectional state of Example 3 shown in Fig. 4, an advanced level of the fusion of silver particles is seen. In contrast, the fusion of silver particles in the cross-sectional state of Comparative Example 1 shown in Fig. 5 is less advanced than in Example 3. The conductive paste of the present invention can offer low specific resistance probably because silver particles are fused to an advanced level by the use of the specified cationic polymerization initiator. However, the present invention is not bound to this assumption.

**[Table 1]**

| | | Ex. 1 | Ex. 2 | Ex. 3 | Ex. 4 | Ex. 5 | Ex. 6 | Ex. 7 |
|---|---|---|---|---|---|---|---|---|
| Conductive components | Silver particles A | 100 | 100 | 100 | 100 | 100 | 100 | 100 |
| | Silver particles B | | | | | | | |
| Thermosetting resins | Epoxy resin A | | | | | | | |
| | Epoxy resin B | | | | | | | |
| | Epoxy resin C | 5.06 | 5.06 | 5.06 | 5.06 | 5.06 | 5.06 | 5.06 |
| Cationic polymerization initiators | Polymerization initiator A | 0.21 | 0.32 | 0.42 | 0.53 | 0.63 | 0.84 | 1.68 |
| | Polymerization initiator B | | | | | | | |
| | Polymerization initiator C | | | | | | | |
| | Polymerization initiator D | | | | | | | |
| | Polymerization initiator E | | | | | | | |
| Solvents | Solvent A | 7.5 | 7.5 | 7.5 | 7.5 | 7.5 | 7.5 | 7.5 |
| | Solvent B | | | | | | | |
| Phenoxy resin | | | | | | | | |
| Coupling agent | | 0.20 | 0.20 | 0.20 | 0.20 | 0.20 | 0.20 | 0.20 |
| Measurement results | Specific resistance (µΩ·cm) | 9.8 | 7.9 | 7.8 | 8.3 | 8.8 | 8.3 | 9.5 |
| | Contact resistance (mΩ·cm²) | 4.8 | 5.1 | 6.3 | 4.9 | 6.0 | 5.7 | 5.4 |
| | Printing characteristics | ○ | ○ | ○ | ○ | ○ | ○ | ○ |

**[Table 2]**

| | | Ex. 8 | Ex. 9 | Ex. 10 | Comp. Ex. 1 | Comp. Ex. 2 | Comp. Ex. 3 | Comp. Ex. 4 |
|---|---|---|---|---|---|---|---|---|
| Conductive components | Silver particles A | 75 | 100 | 100 | 100 | 100 | 100 | 100 |
| | Silver particles B | 25 | | | | | | |
| Thermosetting resins | Epoxy resin A | | | | | | | |
| | Epoxy resin B | | | | | | | |
| | Epoxy resin C | 5.06 | 5.06 | 5.06 | 5.06 | 5.06 | 5.05 | 5.05 |
| Cationic polymerization initiators | Polymerization initiator A | 1.68 | 0.32 | 0.32 | | | | |
| | Polymerization initiator B | | | | 0.21 | | | |
| | Polymerization initiator C | | | | | 0.21 | | |
| | Polymerization initiator D | | | | | | 0.21 | |
| | Polymerization initiator E | | | | | | | 0.21 |
| Solvents | Solvent A | 7.5 | | 7.5 | 6.4 | 6.4 | 0.75 | 0.75 |
| | Solvent B | | 7.5 | | | | | |
| Phenoxy resin | | | | | | | | |
| Coupling agent | | 0.20 | 0.20 | | 0.20 | 0.20 | 0.20 | 0.20 |
| Measurement results | Specific resistance (µΩ·cm) | 9.9 | 9.5 | 7.9 | 22.7 | 15.3 | 12.7 | 14.8 |
| | Contact resistance (mΩ·cm²) | 6 | 5.2 | 5.8 | 5.2 | 5.7 | 4.9 | 5.1 |
| | Printing characteristics | ○ | ○ | ○ | ○ | ○ | ○ | ○ |

**[Table 3]**

| | | Ex. 11 | Ex. 12 | Ex. 13 | Ex. 14 | Ex. 15 | Ex. 16 | Ex. 17 |
|---|---|---|---|---|---|---|---|---|
| Conductive components | Silver particles A | 100 | 100 | 100 | 100 | 100 | 100 | 100 |
| | Silver particles B | | | | | | | |
| Thermosetting resins | Epoxy resin A | 2.49 | 2.49 | 2.49 | 2.49 | 2.49 | 2.49 | 2.49 |
| | Epoxy resin B | 3.38 | 3.38 | 3.38 | 3.38 | 3.38 | 3.38 | 3.38 |
| | Epoxy resin C | | | | | | | |
| Cationic polymerization initiators | Polymerization initiator A | 0.21 | 0.32 | 0.43 | 0.53 | 0.64 | 0.85 | 1.06 |
| | Polymerization initiator B | | | | | | | |
| | Polymerization initiator C | | | | | | | |
| | Polymerization initiator D | | | | | | | |
| | Polymerization initiator E | | | | | | | |
| Solvents | Solvent A | 1.06 | 1.06 | 1.06 | 1.06 | 1.06 | 1.06 | 1.06 |
| | Solvent B | 0.74 | 0.74 | 0.74 | 0.74 | 0.74 | 0.74 | 0.74 |
| Phenoxy resin | | 0.32 | 0.32 | 0.32 | 0.32 | 0.32 | 0.32 | 0.32 |
| Coupling agent | | | | | | | | |
| Measurement results | Specific resistance (µΩ·cm) | 6.8 | 6.5 | 6.5 | 6.7 | 6.8 | 6.9 | 7.0 |
| | Contact resistance (mΩ·cm²) | 5.0 | 6.1 | 5.9 | 6.4 | 4.6 | 3.9 | 3.8 |
| | Printing characteristics | ○ | ○ | ○ | ○ | ○ | ○ | ○ |

**[Table 4]**

| Components | Types | Names or models | Manufacturers |
|---|---|---|---|
| Conductive components | Silver particles A (silver flaky particles) | FA-D-5 | DOWA ELECTRONICS MATERIALS CO., LTD. |
| | Silver particles B (silver spherical particles) | AG2-1C | DOWA ELECTRONICS MATERIALS CO., LTD. |
| Thermosetting resins | Epoxy resin A | Diglycidyl 1,2-cyclohexanedicarboxylate | Tokyo Chemical Industry Co., Ltd. |
| | Epoxy resin B | YX8000 | Mitsubishi Chemical Corporation |
| | Epoxy resin C | 154 (phenol novolak epoxy resin) | Mitsubishi Chemical Corporation |
| Cationic polymerization initiators | Polymerization initiator A | CXC1614 | King Industries, Inc. |
| | Polymerization initiator B | CXC2700 | King Industries, Inc. |
| | Polymerization initiator C | CXC 1802 | King Industries, Inc. |
| | Polymerization initiator D | TAG2690 | King Industries, Inc. |
| | Polymerization initiator E | CXC1738 | King Industries, Inc. |
| Solvents | Solvent A (ethylene glycol monophenyl ether) | Hisolve EPH | TOHO Chemical Industry Co., Ltd. |
| | Solvent B (butyl carbitol acetate) | BCA | Wako Pure Chemical Industries, Ltd. |
| Phenoxy resin | | JER1256 | Mitsubishi Chemical Corporation |
| Coupling agent (3-glycidoxypropyltriethoxysilane) | | KBM-403 | Shin-Etsu Chemical Co., Ltd. |

### Reference Signs List

- 10: CRYSTALLINE SILICON SUBSTRATE
- 12: I-TYPE AMORPHOUS SILICON LAYER
- 14a: P-TYPE AMORPHOUS SILICON LAYER
- 14b: N-TYPE AMORPHOUS SILICON LAYER
- 16: TRANSPARENT CONDUCTIVE FILM
- 18a: LIGHT INCIDENT SIDE ELECTRODE
- 18b: BACK ELECTRODE

## Claims

1. A conductive paste comprising (A) a conductive component, (B) a thermosetting resin, (C) a compound having a structure of the formula (1), and (D) a solvent, wherein the compound (C) having the structure of the formula (1) is included in an amount of 0.1 part by weight to 2.0 parts by weight with respect to 100 parts by weight of the conductive component (A).

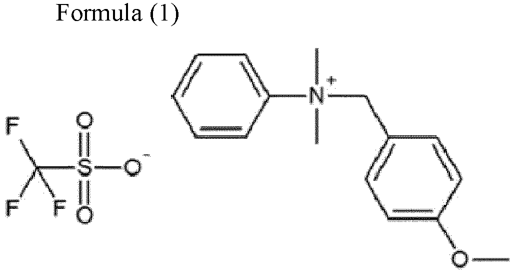

2. The conductive paste according to claim 1, wherein the conductive component (A) comprises at least one selected from silver and copper.

3. The conductive paste according to claim 1 or 2, wherein the conductive component (A) comprises spherical particles and/or flaky particles.

4. The conductive paste according to any one of claims 1 to 3, wherein the thermosetting resin (B) comprises an epoxy resin or an acrylic resin.

5. The conductive paste according to any one of claims 1 to 4, which includes the compound (C) having the structure of the formula (1) in an amount of 0.21 part by weight to 1.68 parts by weight with respect to 100 parts by weight of the conductive component (A).

6. The conductive paste according to any one of claims 1 to 5, wherein the solvent (D) comprises ethyl glycol monophenyl ether or butyl carbitol acetate.

7. The conductive paste according to any one of claims 1 to 6, further comprising (E) a phenoxy resin.

8. The conductive paste according to any one of claims 1 to 7, further comprising (F) a coupling agent.

9. A use of the conductive paste described in any one of claims 1 to 8 for forming a solar cell electrode.

10. A method for forming a solar cell electrode comprising treating the conductive paste according to any one of claims 1 to 8 at a temperature of not more than 250°C.

11. A use of the conductive paste according to any one of claims 1 to 8 for forming an electrode on a surface of a transparent electrode.

## Patentansprüche

1. Leitfähige Paste, umfassend (A) eine leitfähige Komponente, (B) ein wärmehärtendes Harz, (C) eine Verbindung mit einer Struktur der Formel (1), und (D) ein Lösungsmittel, wobei die Verbindung (C) mit der Struktur der Formel (1) in einer Menge von 0,1 Gewichtsteilen bis 2,0 Gewichtsteilen, bezogen auf 100 Gewichtsteile der leitfähigen Komponente (A), enthalten ist.

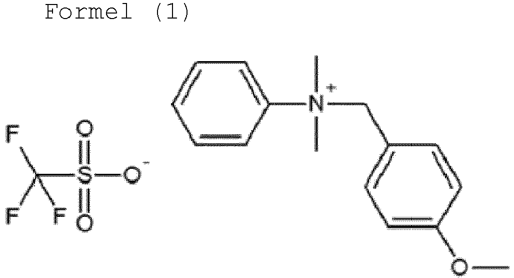

2. Leitfähige Paste nach Anspruch 1, wobei die leitfähige Komponente (A) mindestens eines ausgewählt aus Silber und Kupfer umfasst.

3. Leitfähige Paste nach Anspruch 1 oder 2, wobei die leitfähige Komponente (A) kugelförmige Teilchen und/oder flockige Teilchen umfasst.

4. Leitfähige Paste nach mindestens einem der Ansprüche 1 bis 3, wobei das wärmehärtende Harz (B) ein Epoxidharz oder ein Acrylharz umfasst.

5. Leitfähige Paste nach mindestens einem der Ansprüche 1 bis 4, die die Verbindung (C) mit der Struktur der Formel (1) in einer Menge von 0,21 Gewichtsteilen bis 1,68 Gewichtsteilen, bezogen auf 100 Gewichtsteile der leitfähigen Komponente (A), einschließt.

6. Leitfähige Paste nach mindestens einem der Ansprüche 1 bis 5, wobei das Lösungsmittel (D) Ethylglykolmonophenylether oder Butylcarbitolacetat umfasst.

7. Leitfähige Paste nach mindestens einem der Ansprüche 1 bis 6, die ferner (E) ein Phenoxyharz umfasst.

8. Leitfähige Paste nach mindestens einem der Ansprüche 1 bis 7, die ferner (F) einen Haftvermittler umfasst.

9. Verwendung der in mindestens einem der Ansprüche 1 bis 8 beschriebenen leitfähigen Paste zur Herstellung einer Solarzellenelektrode.

10. Verfahren zur Herstellung einer Solarzellenelektrode, umfassend die Behandlung der leitfähigen Paste nach mindestens einem der Ansprüche 1 bis 8 bei einer Temperatur von nicht mehr als 250°C.

11. Verwendung der leitfähigen Paste nach mindestens einem der Ansprüche 1 bis 8 zur Bildung einer Elektrode auf einer Oberfläche einer transparenten Elektrode.

## Revendications

1. Pâte conductrice comprenant (A) un composant conducteur, (B) une résine thermodurcissable, (C) un composé présentant une structure de la formule (1), et (D) un solvant, dans laquelle le composé (C) ayant la structure de la formule (1) est inclus en une quantité de 0,1 part en poids à 2,0 parts en poids par rapport à 100 parts en poids du composant conducteur (A).

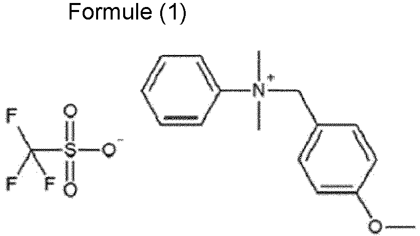

2. Pâte conductrice selon la revendication 1, dans laquelle le composant (A) conducteur comprend au moins un choisi parmi l'argent et le cuivre.

3. Pâte conductrice selon la revendication 1 ou la revendication 2, dans laquelle le composant (A) conducteur comprend des particules sphériques et/ou des particules floconneuses.

4. Pâte conductrice selon l'une quelconque des revendications 1 à 3, dans laquelle la résine (B) thermodurcissable comprend une résine époxy ou une résine acrylique.

5. Pâte conductrice selon l'une quelconque des revendications 1 à 4, qui inclut le composé (C) présentant la structure de la formule (1) en une quantité de 0,21 part en poids à 1,68 part en poids par rapport à 100 parts en poids du composant (A) conducteur.

6. Pâte conductrice selon l'une quelconque des revendications 1 à 5, dans laquelle le solvant (D) comprend de l'éther monophénylique d'éthyl glycol ou de l'acétate de butyl carbitol.

7. Pâte conductrice selon l'une quelconque des revendications 1 à 6, comprenant (E) en outre une résine phénoxy.

8. Pâte conductrice selon l'une quelconque des revendications 1 à 7, comprenant (F) en outre un agent de couplage.

9. Utilisation de la pâte conductrice décrite dans l'une quelconque des revendications 1 à 8 pour former une électrode de cellule solaire.

10. Procédé de formation d'une électrode de cellule solaire comprenant le traitement de la pâte conductrice selon l'une quelconque des revendications 1 à 8 à une température de pas plus de 250 °C.

11. Utilisation de la pâte conductrice selon l'une quelconque des revendications 1 à 8 pour former une électrode sur une surface d'une électrode transparente.
